# DEMANDE DE BREVET EUROPEEN

(11) **EP 2 682 761 A1**
(43) Date de publication de la demande: **08.01.2014**
(21) Numéro de dépôt: 13305870.1
(22) Date de dépôt: 25.06.2013
(51) Int. Cl.: G01R 1/04, G01R 19/00, H02H 3/33, H02B 1/052, G01R 31/28

(54) **Mesure dans un tableau par dispositif placé à l'arrière**

(30) Priorité: 05.07.2012 FR 1256463
(71) Demandeur: Hager-Electro SAS (Société par Actions Simplifiée), 67210 Obernai (FR)
(72) Inventeur: Deckert, Denis, 67190 Mutzig (FR); Poinsignon, Jean Marc, 57220 Fouligny (FR); Fritsch, Jacky, 67100 Strasbourg (FR)
(74) Mandataire: Nuss, Laurent

(57) **Abrégé**

La présente invention a pour objet un dispositif de mesure pour mesurer la consommation d'énergie électrique d'au moins un appareil modulaire destiné à être monté sur un rail (3) dans un tableau électrique présentant un fond, ledit dispositif comprenant des organes de mesure (5) du fonctionnement de l'appareil modulaire agissant à proximité d'une borne dudit appareil. Ce dispositif est caractérisé en ce qu'il comprend un socle (6), présentant une semelle (7), par rapport à laquelle les organes de mesure (5) forment un renvoi, arrangée pour être placée essentiellement entre le fond et l'appareil modulaire, les organes de mesure (5) aboutissant alors au niveau de la ou des bornes.

L'invention a aussi pour objet un tableau comprenant un tel dispositif de mesure.

Application à la distribution de courant dans des installations électriques domestiques ou tertiaires.

## Description

La présente invention relève du domaine des équipements électriques pour l'alimentation d'énergie électrique dans un local à partir d'un tableau de distribution, et a plus particulièrement pour objet, d'une part, un dispositif de mesure, et, d'autre part, un tableau de distribution comprenant un tel dispositif de mesure.

L'électricité dans un local est classiquement apportée depuis un tableau de distribution, comprenant un ensemble d'appareils, de type modulaires, montés sur un ou plusieurs rails, ces appareils assurant généralement une fonction de protection, par exemple contre les surintensités brutales de court circuit, contre les surcharges, contre les fuites à la terre, voire aussi les surtensions.

Il peut être souhaitable de connaître en particulier la quantité d'électricité qui traverse chacun de ces différents appareils, chacun pouvant, en outre, être amené à faire circuler des ampérages différents, à des moments différents. Il peut aussi être souhaitable de mesurer d'autres grandeurs, comme température ou tension.

Un des moyens classiques pour mesurer le courant circulant dans l'appareil est un transformateur de courant, utilisant un effet électromagnétique. Un tel organe de mesure se présente sous la forme essentielle d'un tore, dans lequel vient s'installer un champ magnétique lorsqu'il est traversé par un conducteur, connecté à l'appareil modulaire, et où circule de l'électricité. Ce champ magnétique induit à son tour un courant dans une bobine, ce courant étant représentatif du courant apporté à l'appareil modulaire.

WO2012 041647 propose d'installer un tel organe de mesure autour des conducteurs branchés à l'appareil modulaire. Une diode est alimentée par le courant électrique créé, de sorte à signaler la quantité d'électricité qui circule.

US2011 040506 propose, en outre, d'intégrer, dans un tel organe de mesure, placé en vis-à-vis d'une des bornes de l'appareil modulaire, les moyens de traitement du courant obtenu par la transformation, sous la forme, entre autres, d'une carte de circuit imprimé et d'un processeur. Un des inconvénients d'une telle réalisation est que l'organe de mesure lui-même est complexe et coûteux, et que son installation pour chacun des appareils modulaires peut être très onéreuse, puisque chaque organe de mesure est considéré comme un élément autonome intégrant tous les éléments nécessaires au traitement du signal.

WO2007 143834 propose, quant à lui, une barre de mesure, présentant une pluralité d'orifices, chacun pouvant être traversé par un conducteur branché à l'un des appareils. Une telle barre, qui intègre les moyens de mesure de courant, de traitement et de transmission du signal, repose ensuite contre la tranche horizontale des différents appareils. Un des inconvénients majeurs d'une telle réalisation est qu'il peut être souhaitable que les différents organes de mesure aient chacun des calibres différents. En outre, il se peut que certains des organes de mesure ne soient pas utiles, ce qui rend le dispositif encore moins adaptable.

EP 2 408 073 propose une barre du même type, intégrant toutefois, d'une part, la fonction alimentation d'énergie électrique, grâce aux broches d'un peigne qu'elle contient, et, d'autre part, la fonction de mesure, grâce à des tores démontables. La barre est, en outre, munie de LED pour afficher l'état de circulation d'énergie. Un des inconvénients de ce type d'équipement est que son encombrement peut se révéler gênant, puisqu'une telle barre doit là encore reposer ensuite sur les faces horizontales des appareils alignés. De plus, la présence d'une telle barre peut aussi gêner le démontage des appareils auxquels elle est branchée.

La présente invention a pour but de pallier au moins une partie et préférentiellement tous ces inconvénients, et vise donc notamment à proposer un équipement permettant d'obtenir une mesure du fonctionnement d'un appareil modulaire, en particulier une mesure du courant circulant dans les différents appareils modules, tenant compte des contraintes géométriques d'un montage dans un tableau équipé, ce dispositif étant, en outre, aisément adaptable à la mesure à effectuer et ne gênant pas le démontage des appareils modulaires.

A cet effet, l'invention a pour objet un dispositif de mesure, pour mesurer le fonctionnement électrique d'au moins un appareil modulaire destiné à être monté sur un rail dans un tableau électrique présentant un fond,
ledit dispositif comprenant au moins un organe de mesure pour mesurer une grandeur représentative du fonctionnement de l'appareil modulaire et ce dans l'environnement d'une borne dudit appareil, notamment le courant circulant dans un conducteur branché à la borne.

Ce dispositif est **caractérisé en ce que** le dispositif de mesure comprend un socle, présentant une semelle, par rapport à laquelle le au moins un organe de mesure forme un renvoi, arrangée pour être placée essentiellement entre le fond et l'appareil modulaire, le au moins un organe de mesure aboutissant alors au niveau de la borne.

Ainsi, le dispositif limite son encombrement en tirant profit du volume existant à l'arrière de l'appareil modulaire, en direction du fond du tableau.

L'invention a aussi pour objet un tableau électrique, pour la connexion d'un ensemble d'appareils modulaires,
présentant un fond et comprenant au moins un rail pour la fixation des appareils modulaires, ainsi que des montants de structure, notamment essentiellement rectilignes.

Ce tableau est **caractérisé en ce que** il comprend au moins un dispositif de mesure tel que décrit ci-dessus, monté de sorte à pouvoir mesurer un paramètre de fonctionnement d'un appareil modulaire fixé au rail, et ce au niveau d'une borne de connexion électrique de puissance dudit appareil.

L'invention sera mieux comprise, grâce à la description ci-après, qui se rapporte à un mode de réalisation préféré, donné à titre d'exemple non limitatif, et expliqué avec référence aux dessins schématiques annexés, dans lesquels :
- les figures 1 et 2 sont des vues de côté d'une partie d'un tableau électrique selon l'invention, dans lequel est monté est dispositif de mesure selon l'invention ;
- la figure 3 montre un dispositif de mesure selon l'invention, et
- la figure 4 illustre l'intérieur d'un tableau électrique selon l'invention, comprenant plusieurs dispositifs de mesure selon l'invention ;
- la figure 5 montre un arrangement géométrique particulier concernant la géométrie des organes de mesure, les borniers de raccordement à la semelle et les appareils modulaires.

L'invention a donc tout d'abord pour objet un dispositif de mesure 1, pour mesurer le fonctionnement électrique d'au moins un appareil modulaire 2 destiné à être monté sur un rail 3 dans un tableau électrique présentant un fond 4,
ledit dispositif comprenant au moins un organe de mesure 5 pour mesurer une grandeur représentative du fonctionnement de l'appareil modulaire 2 et ce dans l'environnement d'une borne 8 dudit appareil, notamment le courant circulant dans un conducteur branché à la borne 8.

Le tableau électrique, généralement sous forme de caisson parallélépipédique comprenant un ou plusieurs rails 3 transversaux et décalés du fond 4 du tableau, comporte généralement une quantité d'appareils modulaires 2 qui peuvent être du type disjoncteur de surcharge, différentiel, voire parafoudre. Ils sont conçus pour un montage sur un rail 3 de conception standard, rail DIN, et présentent donc à cet effet un moyen d'accrochage mécanique compatible. Le tableau électrique peut aussi consister en un simple coffret, dans lequel les appareils modulaires sont ensuite montés et câblés.

Le fond 4 peut être fermé par une cloison, ou ouvert, laissant ensuite apparaître la paroi contre laquelle le tableau est monté. Le tableau présente forcément une partie de façade, frontale, au niveau de laquelle un utilisateur peut manipuler les appareils modulaires, cette façade étant éventuellement fermée par une porte. Le fond 4 se trouve en vis-à-vis de la façade, et est normalement directement posé contre le mur ou paroi de fixation du tableau.

Les organes de mesure 5 surveillent donc le fonctionnement de l'appareil modulaire 2, au niveau d'une de ses bornes 8, donc à l'extérieur de ce dernier. Un tel organe de mesure 5 peut ainsi relever une température dans l'environnement immédiat de la borne 8, mais aussi, avantageusement, relever l'ampérage du courant circulant dans un conducteur relié à la borne 8. Une réalisation classique d'un organe de mesure 5, dans le cas où il doit mesurer le courant circulant dans la conducteur et qui transite donc par l'appareil modulaire 2, comprend, comme organe essentiel de la mesure, un tore métallique, que traverse le conducteur. Le flux magnétique qui s'installe dans le tore métallique est ensuite transformé en courant électrique grâce à une bobine, l'organe de mesure 5 agissant alors comme un transformateur de courant, ce dernier étant de très faible consommation.

Une autre façon de réaliser la mesure de courant est, par exemple, d'utiliser un effet Hall pour quantifier l'intensité circulant dans le conducteur, et donc consommée par l'appareil modulaire 2, dans le cas où la mesure est effectuée en amont, ou fournie par lui, dans le cas où la mesure est effectuée en aval.

L'organe de mesure 5 peut, aussi comprendre des moyens d'indication de la mesure, par exemple par LED, la couleur étant représentative de la valeur mesurée, ou avec plusieurs LED, chacune d'elle représentant une portion supplémentaire de la capacité totale de l'appareil modulaire 2.

Selon l'invention, le dispositif de mesure 1 comprend un socle 6, présentant une semelle 7, par rapport à laquelle le au moins un organe de mesure 5 forme un renvoi, arrangée pour être placée essentiellement entre le fond 4 et l'appareil modulaire 2, le au moins un organe de mesure 5 aboutissant alors au niveau de la borne 8, le socle 6 étant notamment arrangé pour être fixé sur le rail 3 existant dans le tableau ou comprenant lui-même un rail 3, en substitution de celui existant dans le tableau pour l'accueil des appareils modulaires 2.

Comme il sera encore décrit plus loin, la conception du dispositif de mesure 1 de sorte qu'une partie de ses composants peut se trouver à l'arrière de l'appareil modulaire 2 permet, d'une part, de limiter l'encombrement, et, d'autre part, d'augmenter les capacités fonctionnelles du dispositif, puisqu'un volume plus grand est disponible pour accueillir les éléments nécessaires à de telles fonctions supplémentaires. Classiquement, les rails 3 sont légèrement décalés du fond 4, de l'ordre de quelques centimètres, de sorte à pouvoir y passer notamment des câbles reliés aux appareils modulaires. Les rails 3 sont ainsi généralement posés sur des montants 9, garantissant l'espace entre les appareils modulaires 2 et le fond.

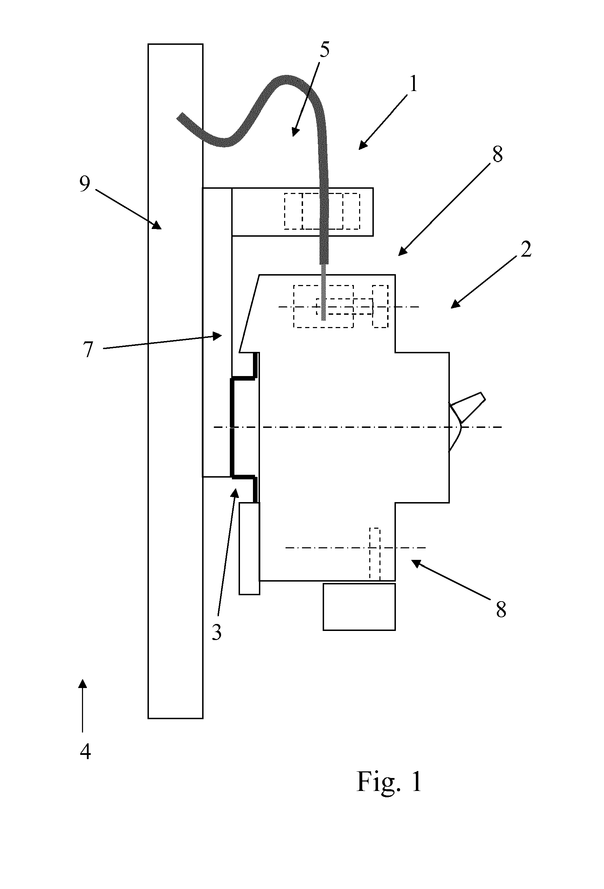

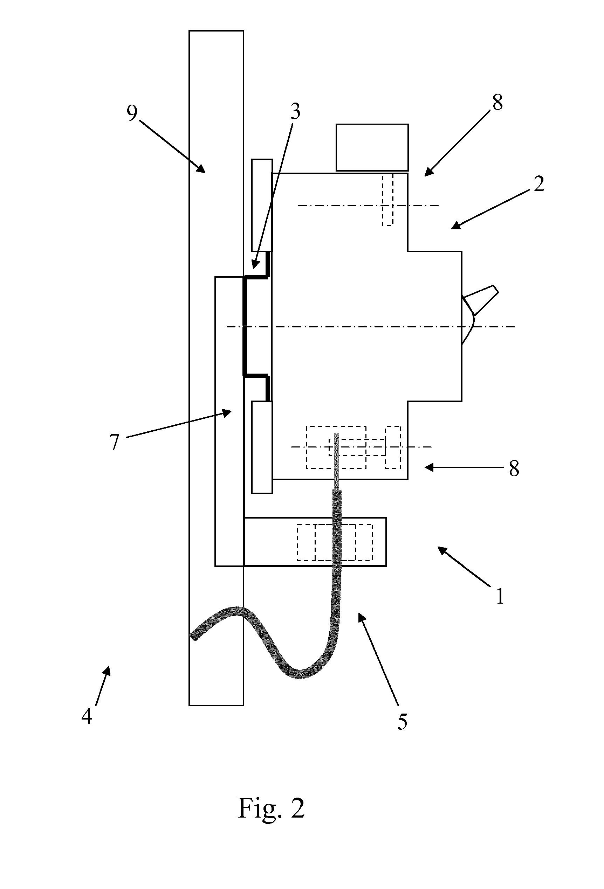

Les figures 1 et 2 montrent que la semelle 7 est arrangée pour s'étendre, dans la direction de haut en bas de ces figures, à partir du rail de fixation des appareils modulaires 2 jusqu'à au-delà des appareils modulaires 2 eux-mêmes. Il convient ici de noter que les appareils modulaires 2 ont généralement des dimensions équivalentes, mesurées de haut en bas des figures 1 et 2. Il reste bien entendu envisageable que la semelle 7 s'étende de part et d'autre du rail 3, ce qui augmente ainsi son encombrement mais surtout le volume qu'elle met à disposition pour l'accueil des composants.

La semelle 7 prend ainsi une forme essentiellement parallélépipédique rectangle : sa largeur, dont la direction correspond normalement à celle dans laquelle s'étend le rail, correspond préférentiellement à un nombre entier de fois la largeur standard d'un appareil modulaire 2, par exemple 6, 12, ou 24 modules, donc à la largeur utile d'un rail 3 classique ; sa hauteur, perpendiculaire à sa largeur et normalement verticale une fois le tableau installé, peut être bien supérieure à celle d'un appareil modulaire 2 classique, toutefois, pour réduire l'impact visuel, la hauteur sera préférentiellement choisie inférieure ; son épaisseur, perpendiculaire aux deux autres dimensions qui forment, elles, le plan principal de la semelle 7, est de l'ordre de quelques millimètres pour ne pas surélever les appareils modulaires 2 si la semelle 7 est entre les montants 9 et le rail 3, voire de plusieurs centimètres si la semelle 7 peut occuper plus d'espace, à savoir la majorité de l'espace entre l'appareil modulaire 2 et le fond 4 du tableau.

Les organes de mesure 5 s'étendent donc perpendiculairement au plan principal de la semelle 7, le socle 6 prenant alors essentiellement un profil en forme de L, une branche du L s'étendant entre l'appareil modulaire 2 et le fond du tableau, l'autre branche s'étendant vers l'avant du tableau, jusqu'à arriver au niveau des bornes 8 pour y effectuer une mesure.

La suite de la description utilise le cas particulier des organes de mesure 5 comprenant un tore métallique pour une mesure de courant par effet magnéto-électrique.

Dans des modes de réalisation particuliers, le socle 6 est fixé sur le rail du tableau électrique, par exemple par des moyens d'accrochage classiques, comme en utilisent les différents appareils modulaires 2. Il peut alors être nécessaire de consacrer une partie du rail à cet ancrage, ce qui peut toutefois être de l'espace perdu, puisqu'aucun autre appareil modulaire 2 ne peut alors y être placé. Ainsi, alternativement, et selon une caractéristique additionnelle possible, le socle 6 comprend, au niveau de la semelle 7, un rail 3 sur lequel le au moins appareil modulaire 2 peut être monté, le rail 3 d'un tableau existant pouvant alors par exemple être ôté et remplacé par le socle 6 comprenant déjà un rail 3 sur lequel monter un appareil modulaire 2. L'avantage d'une telle solution où la semelle 7 et le rail 3 forment un seul ensemble, monobloc, voire indémontable comme lorsque fabriqué d'un seul tenant par moulage plastique, est bien entendu de rendre le dispositif particulièrement compact.

La semelle 7 porte donc un rail 3, et c'est sur ce rail 3 que peuvent être fixés les appareils modulaires 2 dont le dispositif de mesure 1 surveille le fonctionnement, grâce aux organes de mesure 5. Un tel socle 6 vient donc ensuite être placé sur les montants 9, avec des moyens de fixation analogues à ceux utilisés pour fixer un rail classique à de tels montants : vissage, encliquetage, assemblage démontable ou permanent, etc.

Les organes de mesure 5 peuvent être d'un seul tenant avec la semelle 7, ou du moins non démontables. Toutefois, afin de rendre le dispositif de mesure 1 pleinement adaptable aux différentes configurations du tableau, à savoir, en ce qui concerne les appareils modulaires 2, en particulier, le type, le nombre, la localisation, le calibre électrique, il est avantageux de pouvoir disposer d'organes de mesure 5 qui peuvent être séparés de la semelle 7, branchés, par rapport au plan de la semelle 7, perpendiculairement, voire parallèlement.

Ainsi, selon une caractéristique additionnelle possible, le ou au moins un organe de mesure 5 est au moins partiellement amovible et donc au moins partiellement détachable de la semelle 7 du socle 6, qui présente alors notamment les moyens de connexion nécessaires à la connexion de la partie amovible, préférentiellement par enfichage, au niveau d'un socle de connexion pour tout ou partie de l'organe de mesure 5, sous la forme de bornier 11, pour connexion mécanique et/ou électrique. Préférentiellement, l'organe de mesure 5 peut être intégralement séparé de la semelle 7, cette dernière, lorsqu'elle se trouve dépourvue d'organes de mesure 5, prenant donc essentiellement la forme d'une plaque plane, portant éventuellement un rail 3 ou pouvant être fixé à un tel rail 3. La semelle 7 peut aussi comporter un équipement, du gabarit géométrique compatible avec les appareils modulaires 2 classiques, positionné comme s'il était monté sur le rail 3 que porte la semelle 7, cet équipement pouvant alors par exemple regrouper des fonctions d'affichage, de connexion à un bus d'information ou autre.

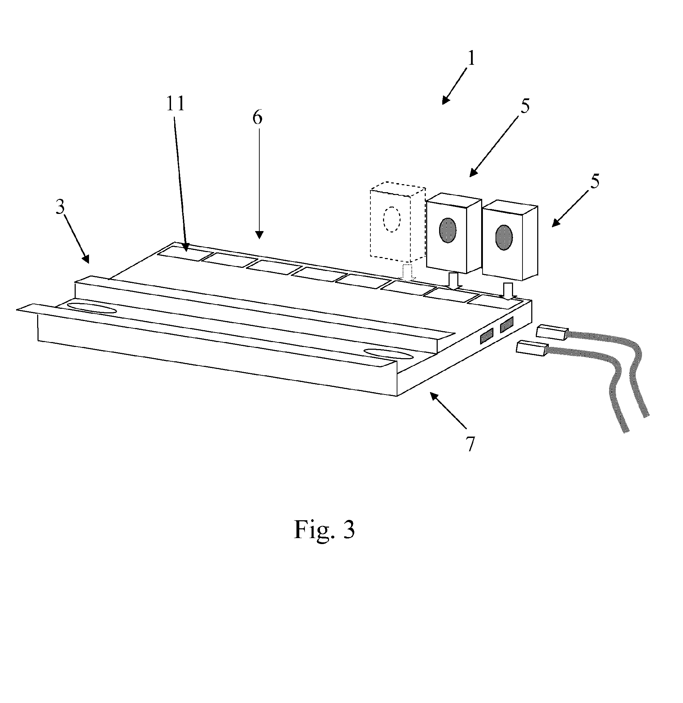

La semelle 7 comporte naturellement des moyens de connexion électrique avec les organes de mesure 5, préférentiellement sous la forme d'un enfichage, ou embrochage, de sorte à réaliser simultanément la connexion mécanique. La direction de cet embrochage est préférentiellement perpendiculaire au plan principal de la semelle 7, comme l'illustre la figure 3. Il reste possible, quoi que moins ergonomique, d'aménager un embrochage sur la tranche de la semelle 7 plutôt que sur sa grande face.

Selon une caractéristique additionnelle possible, le ou au moins un organe de mesure 5 est articulé par rapport à la semelle 7, de sorte à faciliter l'introduction d'un conducteur dans la borne 8 où agit le au moins un organe de mesure 5. En particulier, l'organe de mesure 5 peut être articulé par une liberté de mouvement en rotation autour d'un axe parallèle à l'un des deux côtés du grand rectangle de base de la semelle 7, formé de sa largeur de hauteur. Il est ainsi possible, tout en maintenant l'organe de mesure 5 fixé à la semelle 7, de libérer un peu plus d'espace pour un mouvement de l'appareil modulaire 2, dans le but de le changer, par exemple, ou pour améliorer l'accès à la borne 8 pour un réaliser un branchement.

Selon une caractéristique additionnelle possible, au moins un organe de mesure 5 comprend un tore ouvrable pour y insérer un conducteur pour la borne 8, pour mesurer, par effet magnétoélectrique, le courant circulant dans l'appareil modulaire 2, notamment un conducteur filaire ou une broche d'une barre de pontage. Des tores ouvrables sont en particulier utilisés dans des pinces qu'il suffit d'ouvrir pour les placer autour d'un câble, puis de refermer pour que le courant circulant dans le conducteur soit détecté par une telle pince. Le même principe est donc utilisé dans les modes de réalisation présentant cette caractéristique, ce qui permet d'avoir des organes de mesure 5 fixés, de façon non démontable, à la semelle 7. Il suffit ensuite de les ouvrir pour laisser passer un conducteur filaire connecté à la borne 8 correspondante de l'appareil modulaire 2, ce qui facilite donc la mise en place.

Dans des modes de réalisation particuliers, et selon une caractéristique additionnelle possible, le socle 6 est arrangé pour s'étendre, notamment au niveau de sa semelle 7, dans le prolongement frontal des montants 9 du tableau, ces derniers étant en particulier verticaux une fois le tableau normalement monté. Ainsi, une partie au moins du socle 6, en particulier une partie de la semelle 7, se trouve au niveau des montants 9, ce que montre la figures 1, où la semelle 7 est directement posée contre un montant 9. Dans la figure 2, alternativement, c'est le rail 3 qui est posé contre les montants 9, la semelle 7 s'étendant alors dans l'espace entre le rail 3 et le fond 4, bordé de part et d'autre par les montants 9. Dans les deux cas de figure, à savoir que la semelle 7 du dispositif de mesure 1 aboutisse ou non jusque dans le prolongement frontal des montants 9, c'est-à-dire dans le prolongement des montants perpendiculairement à la paroi contre laquelle le tableau est normalement posé, la semelle 7 peut bien entendu s'étendre aussi, entre les deux montants 9, au-delà de la surface d'appui normale d'un rail 3 en direction du fond 4 du tableau.

Selon une caractéristique avantageuse possible, le socle 6 comprend une unité de contrôle pour traiter la mesure de l'au moins un organe de mesure 5, notamment une unité de contrôle essentiellement placée dans la semelle 7. Cette unité de contrôle peut être analogique ou numérique, et ainsi comprendre un microprocesseur ou des composants d'électronique analogique, monté ou montés sur une carte de circuit imprimé, qui se trouve alors avantageusement dans la semelle 7, à l'arrière des appareils modulaires 2. Dans le cas, fréquemment rappelé à titre d'illustration dans la description, où les organes de mesure 5 sont des transformateurs de courant qui génèrent un courant proportionnel à celui circulant dans le conducteur surveillé, c'est ce courant produit qui peut alors être directement traité comme signal par l'unité de contrôle.

Cette unité de contrôle peut ensuite traiter le signal reçu par les différents organes de mesure 5 de sorte à piloter l'état d'un indicateur, qui peut se trouver au niveau de l'organe de mesure 5 directement, ou encore ailleurs sur le socle 6, par exemple au niveau de l'autre borne 8, non surveillée : l'une des deux bornes 8 présente alors un organe de mesure 5, l'autre borne 8, de l'autre côté, présente alors un indicateur.

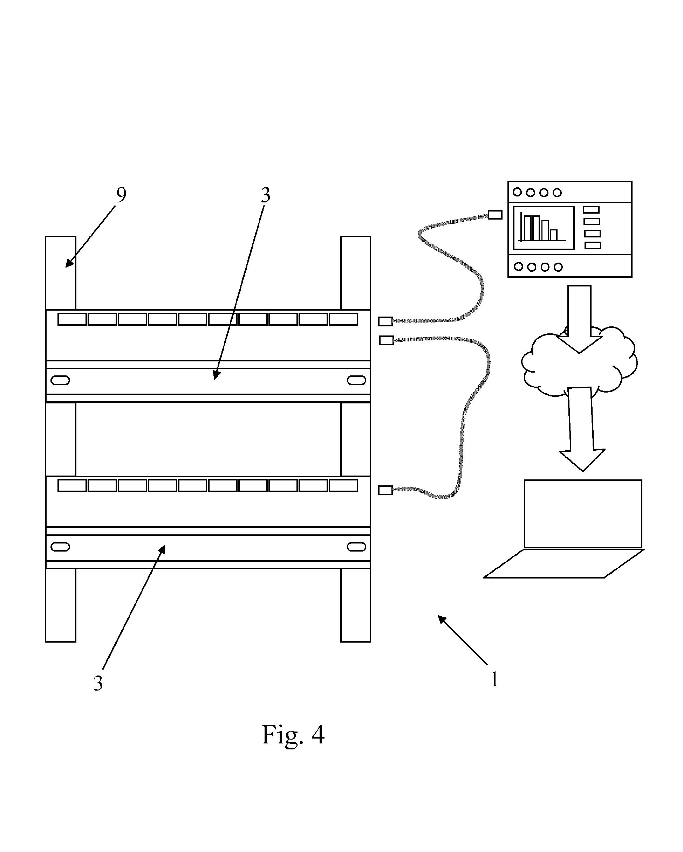

Selon une autre caractéristique additionnelle possible, l'unité de contrôle comprend un moyen de communication, pour envoyer un signal tenant compte des mesures effectuées, notamment un moyen de communication sans fil ou encore un socle de branchement pour câble. Il peut ainsi être avantageux de prévoir, au niveau de la semelle 7 et comme le montrent les figures 3 et 4, des fiches de connexion pour un bus d'information, permettant au dispositif de mesure 1 de communiquer avec d'autres tels dispositifs ou avec un concentrateur, encore décrit plus loin. Le moyen de communication peut aussi consister essentiellement en un moyen de communication sans fil. Dans tous les cas, la communication ainsi réalisée se fait préférentiellement à la fois en émission et en réception. En effet, l'unité de contrôle peut envoyer un signal représentant la mesure effectuée par un ensemble d'organes de mesure 5 à un concentrateur ou à un dispositif d'affichage, par exemple, mais il est aussi possible que des signaux, comme des consignes de paramétrage, soient envoyés à l'unité de contrôle, pour tenir compte des éventuelles différences de calibres et/ou de nature des organes de mesure 5. En effet, dans des modes de réalisations possibles, il comprend une pluralité d'organes de mesure 5 qui n'ont pas tous le même domaine de mesure et/ou la même grandeur mesurée. Ainsi, il est par exemple possible d'avoir un organe de mesure 5 apte à détecter des très faibles courants, inférieurs à un ampère, ainsi qu'un organe de mesure 5 apte à détecter des courants bien plus élevés, de l'ordre de quelques dizaines d'ampères, les différents organes de mesure 5 étant néanmoins montés sur le même dispositif de mesure 1. Il est donc possible, en particulier si les organes de mesure 5 sont des éléments rapportés et enfichés par embroche mécanique et électrique dans la semelle 7, de configurer à souhait le dispositif de mesure 1 pour l'adapter aux différents appareils modulaires 1 du tableau.

Enfin, dans certains cas particuliers de réalisation, l'unité de contrôle comprend un concentrateur, apte à traiter des signaux générés par une pluralité de tels dispositifs de mesure 1 au moyen des organes de mesure 5. Il est en effet possible, comme l'illustre la figure 4, que le tableau soit muni de plusieurs dispositifs de mesure 1, et que au moins l'un d'entre eux comprennent le concentrateur, ce qui peut aussi être particulièrement nécessaire lorsque le dispositif de mesure 1 est le seul du tableau, mais qu'il reste souhaitable que l'information générée par l'unité de contrôle soit envoyée à l'extérieur et donc rendue disponible, par exemple sur un réseau internet.

Ainsi, dans le mode particulier de réalisation illustré en particulier à la figure 1, le dispositif de mesure 1 comprend un socle 6 présentant une semelle 7. Un rail 3 pour fixer l'appareil modulaire 2 fait corps avec la semelle 7, comme le montre encore la figure 3. Le rail 3 et la semelle 7 peuvent par exemple former une seule pièce ou un assemblage. La semelle 7 est destinée à être fixée aux montants 9 du tableau électrique. Le rail 3 qu'elle porte est ainsi légèrement avancé par rapport à la position d'un rail classique, directement apposé contre les montants 9. La fixation entre, d'une part, le socle 6, au niveau de la semelle 7, et, d'autre part, les montants 9, peut se faire par tout moyen connu : vissage, encliquetage, ou autre forme d'assemblage, démontable ou non.

La semelle 7 prend donc essentiellement la forme d'une plaque plane, s'étendant entre le fond 4 et un rail 3 sur lequel les appareils modulaires 2 sont fixés, et peut s'étendre verticalement au-delà des appareils modulaires 2, de sorte à pouvoir rapporter, sur la semelle 7, des organes de mesures 5, comprenant un tore permettant de créer un courant représentant l'électricité qui circule dans un conducteur, ici filaire, qui le traverse et qui vient être branché à l'appareil modulaire 2, au niveau d'une borne 8, généralement borne 8 de sortie.

Des organes de mesure 5 sont mis en place pour les appareils modulaires 2 dont la circulation d'énergie doit être surveillée. En outre, le calibre de l'organe de mesure 5 peut être adapté à chaque appareil modulaire 2.

La semelle 7 comprend, en outre, d'une part, un concentrateur, pour recevoir tous les courants créés par les tores des différents organes de mesure 5 et traiter ces courants, et, d'autre part, au moins une borne de connexion filaire pour une communication avec une centrale de collecte et de traitement de données, comme le montre la figure 4, ou encore avec d'autres tels dispositifs de mesure 1. La figure 4 montre aussi que l'information peut ensuite aisément être envoyée sur un réseau tel que l'internet, et traité par un ordinateur déporté, smartphone ou autres.

Afin de réduire l'encombrement du dispositif de mesure 1 au niveau des bornes 8 de l'appareil modulaire 2, les moyens de traitement du signal fourni par les organes de mesure 5 sont placés dans la semelle 7, l'organe de mesure 5 pouvant être placé au plus près de la borne 8 sans nécessiter beaucoup de place.

Comme l'organe de mesure 5 n'est pas lié mécaniquement directement à l'appareil modulaire 2, ce dernier est aisément remplacé : il suffit de déconnecter le câble de la borne 8, et de retirer l'appareil modulaire 2. L'organe de mesure 5 peut ensuite être retiré sans aucun danger, changé, ou conservé. Il reste alors à connecter un autre appareil modulaire 2 puis à le fixer au rail 3.

La figure 3 montre en outre que les organes de mesure 5, ainsi que leurs éventuels borniers 11 de connexion dans le cas où ils sont entièrement démontables, sont régulièrement répartis avec un pas correspondant à la largeur normale d'un appareil modulaire 2, dite « un module », de sorte que si un premier organe de mesure 5 se trouve en vis-à-vis d'un premier appareil modulaire 2 d'une largeur correspondant à un module, un deuxième organe de mesure 5 se trouvant à côté du premier, arrive en vis-à-vis d'un deuxième appareil modulaire 2, placé à côté du premier, et ainsi de suite. La même régularité géométrique que celle par exemple d'un peigne de pontage se retrouve donc dans cet arrangement. Un pas de plus d'un module est aussi envisageable, bien qu'il suffirait de laisser alors un ou plusieurs borniers 11 de branchement d'organe de mesure 5 inoccupé ou inoccupés, à partir d'une semelle 7 sur laquelle les borniers 11 sont répartis avec un pas correspondant à une largeur d'un module.

Dans certains montages, un équipement électrique d'une largeur correspondant à un demi module peut être inséré entre deux appareils modulaires de largeur un module. Il se crée alors un décalage dans la régularité de la succession des bornes 8 au niveau desquels les organes de mesure 5 doivent mesurer la caractéristique de fonctionnement. Dans le cas particulier d'une mesure de courant par un organe de mesure 5 comprenant un tore dans lequel un conducteur filaire ou rigide doit, ce décalage d'un demi module entre l'organe de mesure 5 et la borne 8 peut être gênant pour le câblage ou même rédhibitoire pour un embrochage de dent de peigne, par exemple.

Afin de palier ce problème tout en conservant à la valeur d'un module le pas de la répartition géométrique des borniers 11 de connexion d'organe de mesure 5, et selon une caractéristique additionnelle possible, les organes de mesure 5 sont volontairement asymétriques, de sorte à se décaler d'un côté ou de l'autre du bornier 11, suivant la position dans laquelle ils y sont branchés. Ainsi, un tel premier organe de mesure 5, branché dans un premier bornier 11, sera placé dans une première position pour que le tore dans lequel le conducteur passe se trouve en vis-à-vis d'un premier appareil modulaire 2, correctement aligné avec la borne 8 de branchement du conducteur traversant le tore. Un deuxième organe de mesure 5, branché dans un deuxième bornier 11 situé juste à côté du premier, sera placé dans une deuxième position, différente de celle du premier organe de mesure 5, ce qui, profitant ainsi de la dissymétrie de l'organe de mesure 5, aura pour effet d'amener le tore de ce deuxième organe de branchement en vis-à-vis de la borne 8 d'un deuxième appareil modulaire 2, séparé du premier par un équipement d'une largeur d'un demi module.

La différence de positions entre celle du premier organe de mesure 5 et celle du deuxième organe de mesure 5 peut être, par exemple, une rotation d'une demi tour autour d'un axe médian, ce dernier étant horizontal et perpendiculaire au mur, une fois l'organe de mesure 5 monté dans un tableau normalement posé. La fiche de connexion de l'organe de mesure 5 sur son bornier 11 est alors normalement décalée par rapport au tore, les borniers 11 pour organes de mesure 5, prévus sur la semelle 7, étant alors eux-mêmes aussi légèrement décalés par rapport aux bornes 8 des appareils modulaires 2. Ainsi, tant que les appareils placés les uns contre les autres sont de largeur un module, les organes de mesure 5 seront tous placés dans la même position, leur tore aboutissant légèrement décalé par rapport au bornier 11 d'enfichage, mais au niveau de la borne 8. Si un décalage d'un demi module intervient dans la succession des appareils modulaires 2, il suffira de changer la position de branchement de l'organe de mesure 5, son tore se décalant alors de l'autre côté que dans la position précédente, par rapport à sa fiche de branchement au bornier 11, la distance entre les deux tores correspondant alors à un demi module et au moins un module.

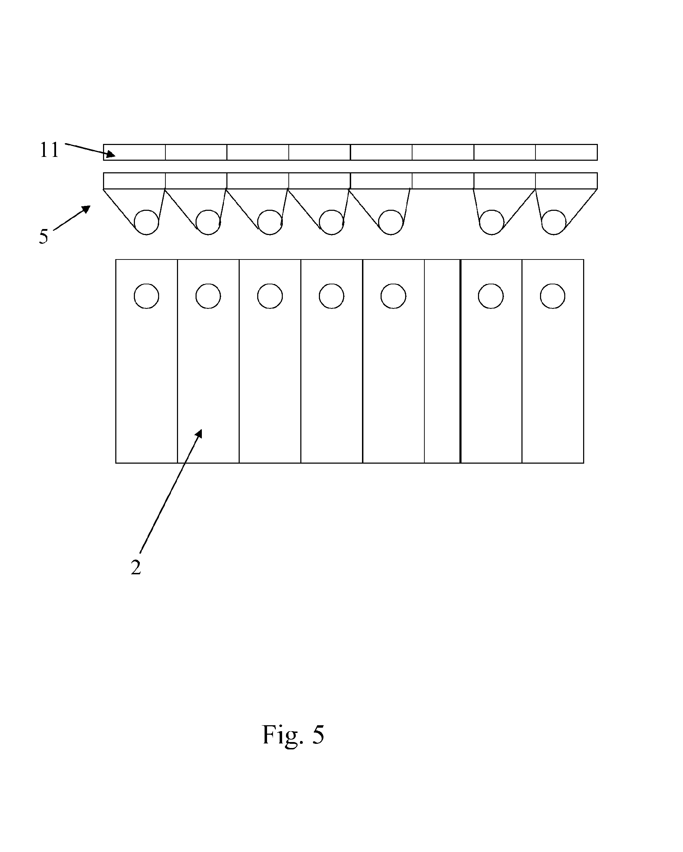

La figure 5 montre un arrangement géométrique possible.

L'invention a aussi pour objet un tableau électrique, pour la connexion d'un ensemble d'appareils modulaires 2,
présentant un fond 4 et comprenant au moins un rail 3 pour la fixation des appareils modulaires 2, ainsi que des montants 9 de structure, notamment essentiellement rectilignes, voire aussi perpendiculaires au rail 3. Le rail 3, une fois le tableau normalement installé, est généralement horizontal et parallèle à la paroi sur laquelle le tableau est fixé. Les montants 9 étant alors généralement très proches de la paroi, ou mur, sur lequel le tableau est fixé, et verticaux. Ils peuvent être directement plaqués contre cette paroi. Ces montants 9 apportent une rigidité au tableau et permettent le maintien du rail 3, sur lequel sont ensuite fixés les appareils modulaires 2.

Leur configuration mécanique peut bien entendu être plus élaborée que simplement deux barres rectilignes parallèles. Comme il a déjà été développé plus haut, les appareils modulaires peuvent être du type disjoncteur de surcharge, disjoncteur différentiel, ou encore parafoudre, et présentent une largeur, dans la direction du rail 3, qui est standard pour un montage sur un rail DIN.

Selon l'invention, ce tableau électrique comprend au moins un dispositif de mesure tel que décrit ci-dessus, monté de sorte à pouvoir mesurer un paramètre de fonctionnement d'un appareil modulaire 2 fixé au rail 3, et ce au niveau d'une borne 8 de connexion électrique de puissance dudit appareil, en particulier mesurer la quantité de courant circulant dans un conducteur relié à ladite borne 8. La semelle 7 du au moins un dispositif de mesure 1 est donc placé à l'arrière de l'appareil modulaire 2, c'est-à-dire entre l'appareil modulaire 2 et le fond 4 du tableau, cette semelle 7 étant alors peu visible et profitant autant que possible du volume disponible dans le tableau à cet endroit. Le au moins un organe de mesure 5 de l'au moins un dispositif de mesure 1 arrive donc en renvoi à cette semelle 7, s'étendant alors sensiblement horizontalement une fois le tableau normalement placé, et aboutissant au niveau d'une des bornes 8 de connexion électrique de l'appareil modulaire 2, qu'il s'agisse de son entrée ou de sa sortie.

En particulier, selon une caractéristique additionnelle possible, le au moins un dispositif de mesure 1 est monté de sorte que les organes de mesure 5 peuvent se trouver au niveau des bornes 8 d'alimentation d'appareils modulaires 2 fixés au rail 3 et détecter ainsi le courant circulant dans des conducteurs reliés électriquement aux appareils modulaires 2 par ces bornes 8, ces conducteurs étant préférentiellement filaires, une barre de pontage pouvant notamment se trouver au niveau des bornes 8 de sortie des appareils modulaires 2. Cette configuration est illustrée dans les figures 1 et 2, la mesure s'effectuant au niveau d'une des bornes 8 de l'appareil modulaire 2, l'alimentation se faisant au niveau de la borne 8 opposée, grâce à une barre de pontage. L'alimentation et la mesure se font donc au niveau de deux bornes 8 différentes.

Toutefois, dans des modes de réalisation particulier, il est possible que le dispositif de mesure 1 remplisse aussi lui-même la fonction d'alimentation, et comprenne alors aussi des fiches de connexion électrique aux bornes 8 des appareils modulaires 2. Le dispositif de mesure 1 est alors lui aussi câblé en puissance, puis redistribue l'électricité aux différents appareils modulaires 2 qui lui sont connectés, des organes de mesure 5 se trouvant alors au niveau des conducteurs utilisés pour relier l'appareil modulaire 2 au dispositif de mesure 1 qui est alors aussi un dispositif d'alimentation. Le dispositif de mesure 1 peut alors aussi intégrer un voltmètre pour quantifier la tension fournies aux appareils modulaires 2. Il est ainsi possible que l'organe de mesure 5 intègre directement aussi la fonction de transmission de l'énergie électrique de puissance, consistant alors, par exemple, en un élément amovible, à relier, d'une part, à l'appareil modulaire 2 pour une transmission de courant de puissance, puis, d'autre part, au reste du socle 6, précisément à la semelle 7, pour une transmission de courant de puissance et de signal représentant effectivement la quantité d'électricité qui circule.

Selon une caractéristique additionnelle possible, la semelle 7 du au moins un dispositif de mesure 1 s'étend au moins pour partie entre les montants 9 et le rail 3. La semelle 7 est ainsi prise entre le rail 3 et le montant 9 et sert alors à maintenir le rail 3 par rapport aux montants 9. Comme il a déjà été développé, la semelle 7 et le rail 3 peuvent être d'un seul tenant, et former une seule pièce.

Enfin, selon une autre caractéristique additionnelle possible du tableau électrique, il comprend une pluralité de dispositifs de mesure 1 ainsi qu'un moyen d'échange d'informations entre eux, notamment un moyen d'échange filaire par bus d'information ou un moyen de communication sans fil.

Les résultats des mesures effectuées par les différents organes de mesure 5 sont ainsi collectés par un concentrateur, qui peut les envoyer vers un poste de traitement déporté : centrale domotique, ordinateur, téléphone, etc.

Dans le mode de réalisation illustré à la figure 1, le dispositif de mesure 1 est monté de sorte que les organes de mesure 5 se trouvent au dessus de l'appareil modulaire 2, en vis-à-vis des bornes 8 correspondant à la sortie de l'appareil modulaire 2. Le dispositif de mesure 1 est directement placé sur les montants 9, éventuellement en substitution d'un rail classique alors démonté pour prendre sa place. A la borne 8 opposée, une barre de pontage relie les différents appareils modulaires 2 placés côte à côte, pour l'alimentation des appareils.

Dans la réalisation de la figure 2, le montage est essentiellement inversé : les organes de mesure 5 se trouvent verticalement en dessous des bornes 8, celles-ci correspondant toutefois encore aux sorties des appareils modulaires 2. Là encore, les bornes 8 d'entrée des appareils modulaires 2 sont reliées par une barre de pontage. Cette figure illustre aussi que le rail 3 se retrouve contre les montants 9, sans semelle 7 entre eux, et est donc placé à la même distance par rapport au fond du tableau qu'un autre rail 3 fixé directement aux montants 9. Le socle 6 du dispositif de mesure 1 peut ici être rattaché sur un rail existant, du côté opposé à celui où sont normalement montés les appareils modulaires 2, ou intégrer lui-même un rail 3, comme il a déjà été développé.

Bien que les figures 1 et 2 montrent que la mesure effectuée par les organes de mesure 2 est réalisée par un conducteur filaire branché dans une borne 8 et traversant un tore de mesure, il est tout à fait envisageable que le conducteur qui traverse le tore, et donc dans lequel on quantifie la circulation d'énergie électrique, soit une dent, broche, lame ou autres, en particulier une dent d'une barre de pontage, auquel cas le dispositif de mesure 1 peut donc être tel qu'il mesure la circulation d'électricité au niveau des bornes 8 d'entrée des appareils modulaires 2.

La figure 4 montre un tableau de distribution avec plusieurs dispositifs de mesure 1, reliés entre eux de sorte à communiquer, et reliés aussi à une centrale de gestion, qui peut alors servir de concentrateur, et relayer du signal, voire servir à la programmation et au paramétrage des dispositifs de mesure 1.

Bien entendu, l'invention n'est pas limitée au mode de réalisation décrit et représenté aux dessins annexés. Des modifications restent possibles, notamment du point de vue de la constitution des divers éléments, par combinaison différente des caractéristiques présentées ci-dessus, ou par substitution d'équivalents techniques, sans sortir pour autant du domaine de protection de l'invention.

## Revendications

1. Dispositif de mesure (1), pour mesurer le fonctionnement électrique d'au moins un appareil modulaire (2) destiné à être monté sur un rail (3) dans un tableau électrique présentant un fond (4),
ledit dispositif comprenant au moins un organe de mesure (5) pour mesurer une grandeur représentative du fonctionnement de l'appareil modulaire (2) et ce dans l'environnement d'une borne (8) dudit appareil, notamment le courant circulant dans un conducteur branché à la borne (8),
**caractérisé en ce que**
le dispositif de mesure (1) comprend un socle (6), présentant une semelle (7), par rapport à laquelle le au moins un organe de mesure (5) forme un renvoi, arrangée pour être placée essentiellement entre le fond (4) et l'appareil modulaire (2), le au moins un organe de mesure (5) aboutissant alors au niveau de la borne (8).

2. Dispositif de mesure (1) selon la revendication 1, **caractérisé en ce que** le socle (6) comprend, au niveau de la semelle (7), un rail (3) sur lequel le au moins appareil modulaire (2) peut être monté.

3. Dispositif de mesure (1) selon l'une quelconque des revendications 1 ou 2, **caractérisé en ce que**
le ou au moins un organe de mesure (5) est au moins partiellement amovible et donc au moins partiellement détachable de la semelle (7) du socle (6).

4. Dispositif de mesure (1) selon l'une quelconque des revendications 1 à 3, **caractérisé en ce que**
le ou au moins un organe de mesure (5) est articulé par rapport à la semelle (7), de sorte à faciliter l'introduction d'un conducteur dans la borne (8) où agit le au moins un organe de mesure (5).

5. Dispositif de mesure (1) selon l'une quelconque des revendications 1 à 4, **caractérisé en ce que**
au moins un organe de mesure (5) comprend un tore ouvrable pour y insérer un conducteur pour la borne (8), pour mesurer, par effet magnétoélectrique, le courant circulant dans l'appareil modulaire (2), notamment un conducteur filaire ou une broche d'une barre de pontage.

6. Dispositif de mesure (1) selon l'une quelconque des revendications 1 à 5, **caractérisé en ce que**
le socle (6) est arrangé pour s'étendre, notamment au niveau de sa semelle (7), dans le prolongement frontal des montants (9) du tableau, ces derniers étant en particulier verticaux une fois le tableau normalement monté.

7. Dispositif de mesure (1) selon l'une quelconque des revendications 1 à 6, **caractérisé en ce que**
le socle (6) comprend une unité de contrôle pour traiter la mesure de l'au moins un organe de mesure (5).

8. Dispositif de mesure (1) selon la revendication 7, **caractérisé en ce que**
l'unité de contrôle comprend un moyen de communication, pour envoyer un signal tenant compte des mesures effectuées.

9. Dispositif de mesure (1) selon l'une quelconque des revendications 7 ou 8, **caractérisé en ce que**
l'unité de contrôle comprend un concentrateur, apte à traiter des signaux générés par une pluralité de tels dispositifs de mesure (1) au moyen des organes de mesure (5).

10. Dispositif de mesure (1) selon l'une quelconque des revendications 1 à 9, **caractérisé en ce que**
il comprend une pluralité d'organes de mesure (5) qui n'ont pas tous le même domaine de mesure et/ou la même grandeur mesurée.

11. Tableau électrique, pour la connexion d'un ensemble d'appareils modulaires (2),
présentant un fond (4) et comprenant au moins un rail (3) pour la fixation des appareils modulaires (2), ainsi que des montants (9) de structure, notamment essentiellement rectilignes,
**caractérisé en ce que**
il comprend au moins un dispositif de mesure (1) selon l'une quelconque des revendications 1 à 10, monté de sorte à pouvoir mesurer un paramètre de fonctionnement d'un appareil modulaire (2) fixé au rail (3), et ce au niveau d'une borne (8) de connexion électrique de puissance dudit appareil.

12. Tableau électrique selon la revendication 11, **caractérisé en ce que**
le au moins un dispositif de mesure (1) est monté de sorte que les organes de mesure (5) peuvent se trouver au niveau des bornes (8) d'alimentation d'appareils modulaires (2) fixés au rail (3) et détecter ainsi le courant circulant dans des conducteurs reliés électriquement aux appareils modulaires (2) par ces bornes (8).

13. Tableau électrique suivant l'une quelconque des revendications 11 à 12, **caractérisé en ce que**
la semelle (7) du au moins un dispositif de mesure (1) s'étend au moins pour partie entre les montants (9) et le rail (3).

14. Tableau électrique suivant l'une quelconque des revendications 11 à 13, **caractérisé en ce que**
il comprend une pluralité de dispositifs de mesure (1) ainsi qu'un moyen d'échange d'informations entre eux.
